# EUROPEAN PATENT APPLICATION

(11) **EP 4 255 139 A1**
(43) Date of publication of application: **04.10.2023**
(21) Application number: 21898614.9
(22) Date of filing: 24.11.2021
(51) Int. Cl.: H05K 7/20, H01L 23/367, F28F 21/02, F28F 3/02

(54) **HEAT SINK DEVICE USING GRAPHITE SHEETS AS FINS**

(30) Priority: 27.11.2020 KR 20200162876
(71) Applicant: Amech Inc., Ulsan 44625 (KR)
(72) Inventor: JEON, Je Uk, Pohang-si Gyeongsangbuk-do 37623 (KR)
(74) Representative: Zimmermann, Tankred Klaus
(86) International application number: PCT/KR2021/017430
(87) International publication number: WO 2022/114788

(57) **Abstract**

Disclosed is a heat sink device which uses graphite sheets as fins. The heat sink device according to an embodiment comprises: graphite sheet fins which each have predetermined lengths in the height and width directions and are arranged parallel to each other while being spaced a predetermined distance apart from each other in the depth direction; metallic insert plates which are disposed at one end of the graphite sheet fins in the height direction and are arranged alternately with the graphite sheet fins; and a fixing means which, in the state where the graphite sheet fins and the insert plates are alternately arranged, presses and fixes the graphite sheet fins and the insert plates.

## Description

### Technical Field

Embodiments of the present disclosure relate to a heat sink device capable of managing a temperature of a heat source by discharging heat from the heat source such as an electric/electronic device. For example, a heat sink device in which fins formed of graphite sheets are fixed by a metal base is provided.

### Background Art

An electric/electronic device has a temperature range in which a normal operation of the electric/electronic device is capable of being performed, and heat is generated as the electric/electronic device is operated. Therefore, heat generated during operation should be discharged so that a temperature of the device does not exceed the normal operation range. A heat sink device having fins is one of the devices responsible for such thermal management.

On the basis of the fact that graphite has a very high thermal conductivity, a technology of a heat sink using graphite sheets as fins has been researched. For example, in Korean Patent Application Publication No. 10-2007-0048137, a composite heat sink with a metal base and graphite fins is proposed.

In the conventional technology proposed in the Korean Patent Application Publication No. 10-2007-0048137, a plurality of grooves is machined inside a metal base, and each lower edge of the graphite fins is closely accommodated in each groove so that the fins are attached to the base, and the fins are fixed to the inside of the grooves by using friction coupling, thermal shrink coupling, or an adhesive.

Such a conventional technology has a complicated manufacturing process, so that productivity is reduced. In addition, since a contact surface between the graphite fins and the metal base is not wide and there is no special countermeasure for reducing thermal resistance between the graphite fins and the metal base, a heat dissipation performance of the heat sink falls far short of a performance that can be expected from a thermal conductivity of the graphite fins. In addition, the fins are required to be inserted after the grooves are formed by the machining process, so that it is difficult to manufacture a heat sink having a small size and having a sufficient number of fins since a small distance between the fins is difficult to be realized.

As such, since the graphite sheet has a thermal conductivity significantly higher that a thermal conductivity of copper or aluminum, the graphite sheet is an ideal material for being used as fins of a heat sink device in terms of thermal conductivity, but it is not easy to apply and use the graphite sheet as the fins due to a strength or ductility problem of the graphite sheet.

In addition, since the contact thermal resistance at a contact surface between the graphite sheet fins and the metal base that is for fixing the fins acts as a bottleneck phenomenon, the overall heat dissipation efficiency of the heat sink device is not the same as the heat dissipation efficiency that can be expected by the thermal conductivity of the graphite sheet.

### Disclosure

### Technical Problem

In the present disclosure, there is provided a heat sink device using graphite sheets as fins, the heat sink device having an excellent productivity, having an excellent heat dissipation performance since thermal resistance between the fins and a metal base is small, and being configured such that a distance between the fins is easily adjusted and a very small distance between the fins is capable of being realized.

### Technical Solution

According to an embodiment of the present disclosure, there is provided a heat sink device using graphite sheets as fins, the heat sink device including: graphite sheet fins having a predetermined height and width in a height direction and in a width direction, the graphite sheet fins being arranged parallel to each other while being spaced a predetermined distance apart from each other in a depth direction; insert plates formed of metal material, the insert plates being disposed at one end of the graphite sheet fins in the height direction and being arranged alternately with the graphite sheet fins; and a fixing means configured to press and fix the graphite sheet fins and the insert plates while the graphite sheet fins and the insert plates are in an alternately arranged state.

In addition, the heat sink device using the graphite sheets as the fins according to an embodiment may further include additional insert plates formed of metal material, the insert plates being disposed at other end of the graphite sheet fins in the height direction and being arranged alternately with the graphite sheet fins.

In addition, in the heat sink device using the graphite sheets as the fins according to an embodiment, the fixing means may include a bolt which is formed of metal material and which passes through through-holes formed at corresponding positions of the graphite sheet fins and the insert plates in the depth direction, and may include a nut fixed to the bolt.

In addition, in the heat sink device using the graphite sheets as the fins according to an embodiment, the fixing means may include a fixing plate which is formed of metal material and which is coupled to distal ends of one ends of the graphite sheet fins and the insert plates in the height direction.

In addition, in the heat sink device using the graphite sheets as the fins according to an embodiment, a thermal expansion coefficient of the bolt and a thermal expansion coefficient of the fixing plate may be smaller than a thermal expansion coefficient of the insert plates.

### Advantageous Effects

In the heat sink device using the graphite sheets as the fins according to an embodiment, the heat sink device has the excellent productivity, has excellent heat dissipation performance since the thermal resistance between the fins and the metal base is small, and is configured such that a distance between the fins is easily adjusted. Therefore, a product having a desired distance between fins and having a desired size is capable of being easily manufactured, and a product having an excellent heat dissipation performance while the product has a small size is capable of being manufactured since a very small distance between the fins can be realized compared to a conventional technology.

### Description of Drawings

FIG. 1 is a perspective view illustrating a heat sink device using graphite sheets as fins according to an embodiment of the present disclosure.
FIG. 2 is an exploded perspective view illustrating the heat sink device illustrated in an embodiment in FIG. 1.
FIG. 3 is a perspective view illustrating the heat sink device using the graphite sheets as the fins according to another embodiment of the present disclosure.
FIG. 4 is a perspective view illustrating the heat sink device using the graphite sheets as the fins according to still another embodiment of the present disclosure.

### Mode for Invention

Hereinafter, a heat sink device using graphite sheets as fins according to an embodiment of the present disclosure will be described in detail with reference to attached drawings.

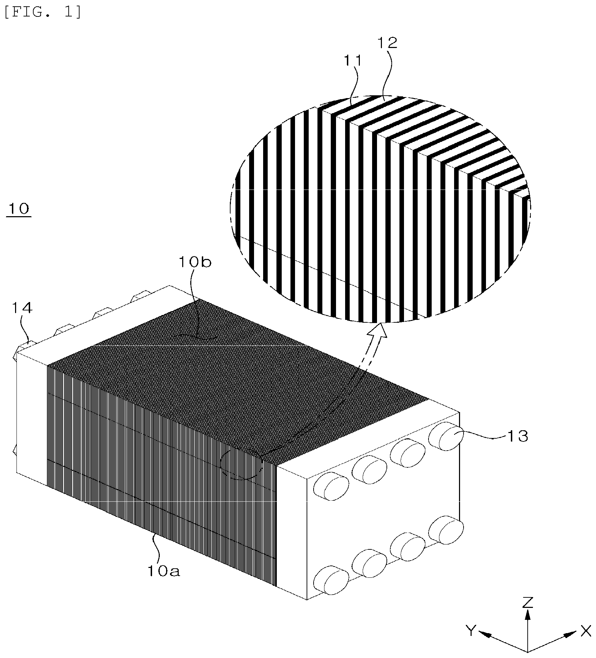

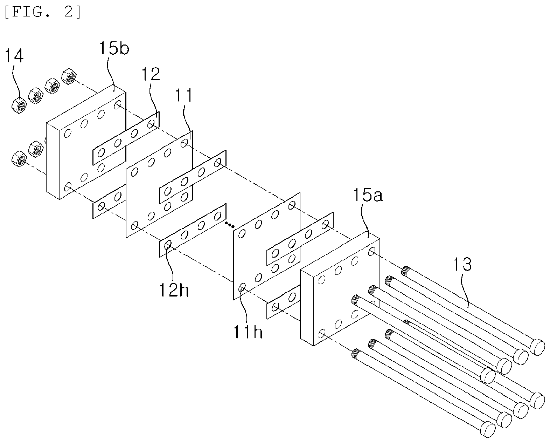

FIG. 1 is a perspective view illustrating a heat sink device 10 using graphite sheets as fins according to an embodiment of the present disclosure, and FIG. 2 is an exploded perspective view illustrating the heat sink device 10.

As illustrated in FIG. 1 and FIG. 2, a heat sink device 10 using graphite sheets as fins (hereinafter, referred to as *'*the heat sink device 10') includes graphite sheet fins 11, insert plates 12, and a fixing means 13 and 14. Since there is no concern of confusion, each of the graphite sheet fins is represented with the same reference numeral 11 regardless of a position thereof, and each of the insert plates is represented with the same reference numeral 12 regardless of a position thereof. In addition, for convenience, the same reference numerals are used only once in the same drawing.

Each of the graphite sheet fins 11 has predetermined lengths in a horizontal direction z and in a width direction x, and is arranged parallel to each other while being spaced a predetermined distance apart from each other in a depth direction y.

The insert plates 12 are positioned at one end of the graphite sheet fins 11 in the height direction z and are arranged alternately with the graphite sheet fins 11, and are formed of metal material. A surface formed at a distal end of one end of the graphite sheet fins 11 in the height direction z is a heat absorption surface 10a that is in close contact with a heat source such as an electric/electronic device and so on. It is preferable that the heat absorption surface 10a is polished smoothly so that the heat absorption surface 10a is in contact with the heat source in a wide area as much as possible.

In the embodiment illustrated in FIG. 1 and FIG. 2, the metallic insert plates 12 are positioned not only at one end of the graphite sheet fins 11 in the height direction z but also at other end of the graphite sheet fins 11 in the height direction z, and are alternately arranged with the graphite sheet fins 11. This arrangement increases durability of the heat sink device 10 so that the heat sink device 10 is more resistant to external shock, and is more effective in closely contacting the graphite sheet fins 11 with the insert plates 12.

However, it is possible that the insert plates 12 are positioned only at one end of the graphite sheet fins 11 in the height direction z (for example, a lower side in the height direction z), and only the graphite sheet fins 11 exist at other end of the graphite sheet fins 11 (for example, an upper side in the height direction z). In this case, the fixing means 13 and 14 may be mounted only at one end of the graphite sheet fins 11 in the height direction z (for example, the lower side in the height direction z), and may not be mounted at other end of the graphite sheet fins 11 in the height direction z (for example, the upper side in the height direction z).

A surface formed at a distal end of other end of the graphite sheet fins 11 in the height direction z is indicated as 10b so as to distinguish the surface from the heat absorption surface 10a.

The fixing means 13 and 14 presses and fixes the graphite sheet fins 11 and the insert plates 12 so that a state in which the graphite sheet fins 11 and the insert plates 12 are alternately arranged is maintained.

In the embodiment illustrated in FIG. 1 and FIG. 2, a bolt 13, which is formed of metal material and which passes through through-holes 11h and 12h formed at corresponding positions of the graphite sheet fins 11 and the insert plates 12 in the depth direction y, and a nut 14 fixed at one end of the bolt 13 are included.

In the embodiment illustrated, the bolt 13 and the nut 14 are only an example of a fixing means configured to press and fix the graphite sheet fins 11 and the insert plates 12 in the depth direction y by passing the bolt 13 through the through-holes 11h and 12h. For example, caulking of an end of a bolt, using a rivet instead of a bolt, or the like may be applied instead of using the bolt 13 and the nut 14, and should be considered equivalent to the bolt 13 and the nut 14.

The inventors of the present disclosure have found out the following technical details. That is, as the adhesion between the graphite sheet fins 11 and the insert plates 12 improves, the contact thermal resistance between the graphite sheet fins 11 and the insert plates 12 decreases, so that the heat dissipation performance expected from the high thermal conductivity of the graphite sheet fins 11 may be realized from the heat sink device 10.

Accordingly, the bolt 13 and the nut 14 are used so as to press and fix the graphite sheet fins 11 and the insert plates 12 such that the graphite sheet fins 11 and the insert plates 12 are pressed. Furthermore, the bolt 13 having a thermal expansion coefficient smaller than a thermal expansion coefficient of the insert plates 12 are selected so that a pressing force by the bolt 13 and the nut 14 increases as the heat sink device receives heat and a temperature of the heat sink device becomes a high temperature. The heat sink device 10 expands in the depth direction y as a temperature of the heat sink device 10 becomes a high temperature, and the thermal expansion coefficient of the bolt 13 is smaller than the thermal expansion coefficient of the insert plates 12. Therefore, the insert plates 12 intend to expand more, but are constrained by a head of the bolt 13 and the nut 14, and do not actually expand. As a result, the pressing force acting on interfaces between the graphite sheet fins 11 and the insert plates 12 is increased. Therefore, as a temperature increases, the pressing force rapidly increases, and the contact thermal resistance between the graphite sheet fins 11 and the insert plates 12 converges to zero, so that a thermal bottleneck phenomenon occurring at the interfaces may be removed.

The reference numerals 15a and 15b represent protective plates for protecting the opposite ends of the heat sink device 10 in the depth direction y and for increasing durability of the heat sink device 10. The protective plates 15a and 15b do not have to be provided.

The heat sink device using graphite sheets as fins, i.e., the heat sink device 10 using graphite sheet fins, is highly productive and has a small thermal resistance between the graphite sheet fins 11 and the insert plates 12, so that the heat dissipation performance is excellent. Furthermore, a heat sink device product having a desired distance and a desired size may be easily manufactured since a distance between the graphite sheet fins 11 is capable of being easily adjusted according to a thickness selection of the insert plates 12. In addition, a very small distance between the graphite sheet fins 11 comparing to a conventional technology may be realized by selecting thin insert plates 12, so that a product having an excellent heat dissipation performance while the product has a small size may be manufactured.

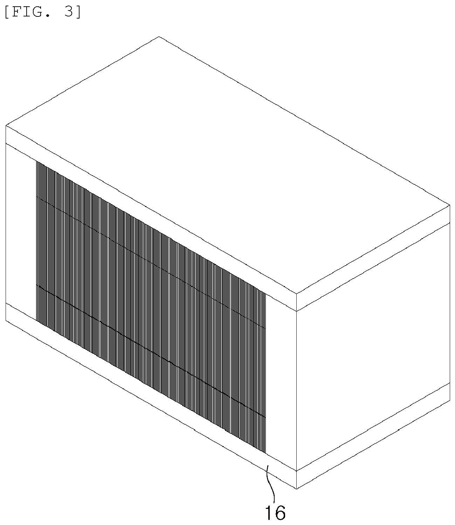

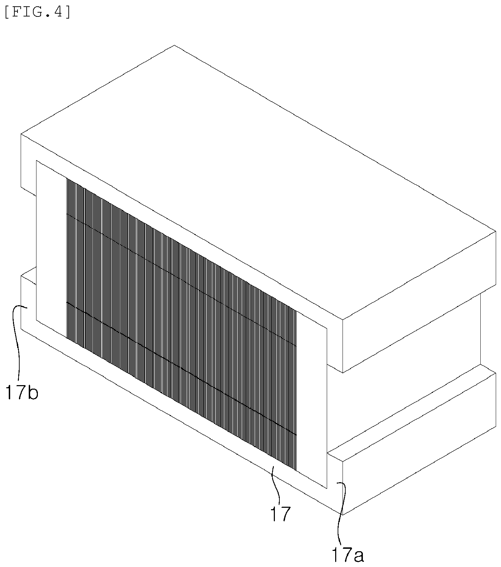

FIG. 3 is a perspective view illustrating the heat sink device using the graphite sheets as the fins according to another embodiment of the present disclosure, and FIG. 4 is a perspective view illustrating the heat sink device using the graphite sheets as the fins according to still another embodiment of the present disclosure.

In embodiments respectively illustrated in FIG. 3 and FIG. 4, when the embodiments are compared to the embodiment illustrated in FIG. 1 and FIG. 2, a different fixing means is used, and the through-holes 11h and 12h of the embodiment illustrated in FIG. 1 and FIG. 2 are not formed since the different fixing means is used. In FIG. 3 and FIG. 4, except for respective fixing plates 16 and 17, reference numerals are not indicated, but components not indicated by reference numerals can be identified as almost the same configuration illustrated in FIG. 1 and FIG. 2. For example, graphite sheet fins and insert plates in FIG. 3 and FIG. 4 are the same as those in FIG. 1 and FIG. 2 except that the through-holes 11h and 12h in the embodiment in FIG. 1 and FIG. 2 are not formed.

In FIG. 1 and FIG. 2, the graphite sheet fins 11 and the insert plates 12 are pressed and fixed by passing the bolt 13 and the nut 14 through the through-holes 11h and 12h. However, in the embodiments respectively illustrated in FIG. 3 and FIG. 4, the respective fixing plates 16 and 17 which are formed of metal material and which are coupled to distal ends of one ends of graphite sheet fins and insert plates in the height direction are included.

In FIG. 3 and FIG. 4, the distal ends of one ends of the graphite sheet fins and the insert plates in the height direction are a surface corresponding to the surface indicated as 10a in FIG. 1.

In the embodiment of FIG. 3, for example, the fixing plate 16 is coupled to distal ends of one ends of the graphite sheet fins and the insert plates in the height direction by welding. In addition to welding, a known coupling means used for coupling metal to metal such as an adhesive used between metals may be used.

In the embodiment of FIG. 4, the fixing plate 17 has opposite sides provided with wing portions 17a and 17b. Therefore, as the graphite sheet fins and the insert plates alternately disposed are forcibly fitted between the wing portions 17a and 17b, the fixing plate 17 is coupled to the distal ends of one ends of the graphite sheet fins and the insert plates in the height direction. In order to strengthen the thermal contact between the fixing plate 17 and the distal ends, it is preferable that the coupling is performed in a state in which a material having an excellent thermal conductivity is placed between the fixing plate 17 and the distal ends.

In the embodiments illustrated in FIG. 3 and FIG. 4, the metallic insert plates 12 are positioned not only at one end of the graphite sheet fins 11 in the height direction z but also at other end of the graphite sheet fins 11 in the height direction z, and are alternately arranged with the graphite sheet fins 11. This arrangement increases durability of the heat sink device 10 so that the heat sink device 10 is more resistant to external shock, and is more effective in closely contacting the graphite sheet fins 11 with the insert plates 12.

However, it is possible that the insert plates 12 are positioned only at one end of the graphite sheet fins 11 in the height direction z (for example, a lower side in the height direction z), and only the graphite sheet fins 11 exist at other end of the graphite sheet fins 11 (for example, an upper side in the height direction z). In this case, the respective fixing plates 16 and 17 may be mounted only at one end of the graphite sheet fins 11 in the height direction z (for example, the lower side in the height direction z), and may not be mounted at other end of the graphite sheet fins 11 in the height direction z (for example, the upper side in the height direction z).

In the embodiments illustrated in FIG. 3 and FIG. 4, the respective fixing plates 16 and 17 having a thermal expansion coefficient smaller than the thermal expansion coefficient of the insert plates are selected. The heat sink device in which the respective fixing plates 16 and 17 are used expands in the depth direction y as a temperature of the heat sink device becomes a high temperature, and the thermal expansion coefficient of the respective fixing plates 16 and 17 is smaller than the thermal expansion coefficient of the insert plates. Therefore, the insert plates intend to expand more, but are constrained by the respective fixing plates 16 and 17, and are not actually expand. As a result, the pressing force acting on interfaces between the graphite sheet fins and the insert plates is increased. Therefore, as a temperature increases, the pressing force rapidly increases, and the contact thermal resistance between the graphite sheet fins and the insert plates converges to zero, so that a thermal bottleneck phenomenon occurring at the interfaces may be removed.

Various expressions (terms, visualized images, and so on) used in the description of the embodiments of the present disclosure are merely selected for the purpose of improving the understanding of the technology.

In addition, the present disclosure has been described by way of a limited number of embodiments for the sake of convenience, and those of ordinary skill in the art would be able to devise new embodiments without departing from the technical spirit of the present disclosure on the basis of the described content.

Accordingly, the claims of the present disclosure should not be limited by some of the expressions shown in the `description of the invention' and 'drawings', but should be interpreted broadly on the basis of the fundamental technical idea contained throughout the specification.

## Claims

1. A heat sink device using graphite sheets as fins, the heat sink device comprising:
graphite sheet fins having a predetermined height and width in a height direction and in a width direction, the graphite sheet fins being arranged parallel to each other while being spaced a predetermined distance apart from each other in a depth direction;
insert plates formed of metal material, the insert plates being disposed at one end of the graphite sheet fins in the height direction and being arranged alternately with the graphite sheet fins; and
a fixing means configured to press and fix the graphite sheet fins and the insert plates while the graphite sheet fins and the insert plates are in an alternately arranged state.

2. The heat sink device of claim 1, further comprising additional insert plates formed of metal material, the insert plates being disposed at other end of the graphite sheet fins in the height direction and being arranged alternately with the graphite sheet fins.

3. The heat sink device of claim 1, wherein the fixing means comprises a bolt which is formed of metal material and which passes through through-holes formed at corresponding positions of the graphite sheet fins and the insert plates in the depth direction, comprises a nut fixed to the bolt, and a thermal expansion coefficient of the bolt is smaller than a thermal expansion coefficient of the insert plates.

4. The heat sink device of claim 1, wherein the fixing means comprises a fixing plate which is formed of metal material and which is coupled to distal ends of one ends of the graphite sheet fins and the insert plates in the height direction, and a thermal expansion coefficient of the fixing plate is smaller than a thermal expansion coefficient of the insert plates.
